# EUROPÄISCHE PATENTSCHRIFT

(11) **EP 2 043 412 B1**
(45) Veröffentlichungstag und Bekanntmachung des Hinweises auf die Patenterteilung: **19.05.2010**
(21) Anmeldenummer: 07019158.0
(22) Anmeldetag: 28.09.2007
(51) Int. Cl.: H05K 1/02, H01L 25/11

(54) **Stromschiene mit Wärmeableitung**
Conductor rail with heat conduction
Rails conducteurs dotés d'une dissipation de chaleur

(43) Veröffentlichungstag der Anmeldung: 01.04.2009
(73) Patentinhaber: Eberspächer Controls GmbH & Co. KG, 76863 Herxheim (DE)
(72) Erfinder: Hegmann, Achim, 76863 Herxheim (DE); Schmidt, Alexander, 76863 Herxheim (DE); Schwarzländer, Otto, 76863 Herxheim (DE); Steinmetz, Andreas, 76863 Herxheim (DE); Uhl, Günter, Dr., 76863 Herxheim (DE); Wandres, Steffen, 76863 Herxheim (DE)
(74) Vertreter: Grünecker, Kinkeldey, Stockmair & Schwanhäusser Anwaltssozietät

(56) Entgegenhaltungen:
- WO-A-98/24279
- DE-A1- 19 518 522
- DE-A1- 19 935 803

## Beschreibung

Die vorliegende Erfindung bezieht sich auf eine elektrische Steuereinheit mit verbesserter Stromzuführung und Wärmeabfuhr sowie auf ein entsprechendes Herstellungsverfahren.

In Steuergeräten bzw. Steuermodulen, wie sie z.B. in der Kfz-Elektrik zum Schalten und Verteilen hoher Ströme eingesetzt werden, stellt das Ein- und Ausleiten der hohen Ströme von oft 100 A bis 200 A und mehr in bzw. aus einer Leiterplatte ein Problem dar, da die Ströme über entsprechend massive mechanische Komponenten wie z.B. Stromschienen oder Hochstrom-Steckverbinder ein- und ausgeleitet werden müssen. Leiterplatten als Schaltungsträger in einem Steuergerät bzw. Steuermodul kommen vorzugsweise immer dann zum Einsatz, wenn zum Schalten und Verteilen der Ströme Halbleiterschalter wie z.B. Feldeffekttransistoren oder Bipolartransistoren mit einer zugehörigen Ansteuerschaltung bestehend aus weiteren elektronischen Bauteilen verwendet werden. Das Dokument DE-A-19 518 522 offenbart ein solches Steuergerät.

Ein konkretes Einsatzgebiet für derartige Steuergeräte ist beispielsweise die Ansteuerung elektrischer Kfz-Zusatzheizungen, bei denen über Heizwiderstände, vorzugsweise sogenannte PTC-Elemente (PTC = positive temperature coefficient), elektrische Energie in Wärme umgewandelt wird und über Radiatoren an einen Luftstrom abgegeben wird. Derartige Zusatzheizungen können mehrere Heizstufen aufweisen, die einzeln oder gemeinsam angesteuert werden. Zur Anpassung der Heizleistung an den Wärmebedarf und/oder die aktuell im Bordnetz verfügbare elektrische Leistung werden die Zusatzheizungen üblicherweise über eine Pulsweitenmodulation angesteuert. Zum Schalten und Verteilen des Heizstroms auf die einzelnen Heizstufen werden dabei die oben erwähnten Halbleiterschalter eingesetzt. Zur Vereinfachung der Montage werden die Heizregister und das zugehörige Steuergerät als bauliche Einheit ausgeführt, wobei die Steuerelektronik in den Rahmen des Heizregisters integriert sein kann.

Alle elektronischen Bauteile werden heute vorzugsweise als oberflächenmontierbare Bauteile, sogenannte SMD-Bauteile, verarbeitet. Hieraus resultiert ein weiteres Problem: Der hohe Stromfluss durch die Halbleiterschalter führt zur einer so starken Eigenerwärmung, dass die Wärme durch spezielle Kühlmaßnahmen aus den Halbleiterschaltern abgeführt werden muss. Da auch die Halbleiterschalter als oberflächenmontierbare Bauteile ausgeführt sind, können diese nicht wie früher oft geschehen auf einfache Weise gegen einen Kühlkörper geschraubt werden. Die Wärme muss zunächst durch die schlecht wärmeleitende Leiterplatte hindurch transportiert werden, um sie dann in einen Kühlkörper einleiten zu können. Die Wärmeausleitung aus dem Halbleiterschalter und Einleitung in einen Kühlkörper wird oft dadurch erschwert, dass in vielen Fällen eine elektrische Isolierung (Potentialtrennung) zwischen dem Halbleiterschalter und dem Kühlkörper erforderlich ist, die den Wärmetransport aus dem Halbleiterschalter in einen Kühlkörper verschlechtert.

Eine Lösung für das Problem der Wärmeabfuhr ist aus der Druckschrift EP 1 395 098 A1 bekannt. Das Problem der Stromein- und Stromausleitung wird durch eine massive Stromschiene, die mit der Leiterplatte verschraubt wird, und durch in die Leiterplatte eingelötete Kontaktfedern gelöst. Die Wärmeabfuhr erfolgt unabhängig von der Stromeinleitung durch in die Leiterplatte eingepresste Wärmeleitelemente, auf die die Halbleiterschalter aufgelötet sind, und durch Kühlkörper, die mit den Wärmeleitelementen verbunden sind.

Nachteile dieses Lösungsansatzes sind die Vielzahl von verschiedenen Komponenten und die unterschiedlichen Fertigungsschritte, die sich in entsprechend hohen Material- und Fertigungskosten auswirken. Außerdem ist es schwierig, eine zuverlässige elektrische Isolierung zwischen dem Kühlkörper und dem Wärmeleitelement, das elektrisch direkt mit dem Halbleiterschalter verbunden ist, zu gewährleisten.

Grundsätzlich lässt sich das Problem der Stromzuführung zu den Halbleiterschaltern und die Wärmeabfuhr aus den Halbleiterschaltern dadurch lösen, dass die Halbleiterschalter auf einen massiven Blechstreifen aus einem gut strom- und wärmeleitenden Material (z.B. aus Kupfer) aufgelötet werden. Den Blechstreifen kann man zusätzlich durch Ausstanzen bzw. Ausprägen von Kühlfingern so gestalten, dass eine gute Wärmeabgabe an die Umgebung erfolgt. Gleichzeitig kann man den Blechstreifen so ausgestalten, z.B. durch Einpressen eines Anschlussbolzens, dass durch Schrauben oder Stecken auf einfache Weise ein Kabel mit einem entsprechend hohen Leitungsquerschnitt zur Stromzuführung angeschlossen werden kann. Auch bei dieser Lösung ist es sehr schwierig, eine zuverlässige elektrische Isolierung zwischen dem Blechstreifen, der elektrisch direkt mit dem Halbleiterschalter verbunden ist, und dessen Umgebung zu gewährleisten.

### ZUSAMMENFASSUNG DER ERFINDUNG

Ziel der vorliegenden Erfindung ist es daher, eine einfache und kostengünstige Lösung der Stromzuführung zu Halbleiterschaltern, die auf einer Leiterplatte montiert sind, und der Wärmeabfuhr aus den Halbleiterschaltern anzugeben. Ein weiteres Ziel der vorliegenden Erfindung ist es, ein entsprechendes Herstellungsverfahren anzugeben.

Dies wird durch die Merkmale der unabhängigen Ansprüche erreicht. Bevorzugte Ausführungsformen sind Gegenstand der abhängigen Ansprüche.

Es ist der besondere Ansatz der vorliegenden Erfindung, zur Stromzu- und Wärmeabfuhr eine Stromschiene zu verwenden, die über ein Wärmeleitelement sowohl in elektrischem als auch in thermischem Kontakt mit dem Halbleiterschalter steht, so dass die beim Betrieb entstehende Wärme über einen auf der Stromschiene angeordneten Kühlkörper abgeführt wird.

Gemäß einem ersten Aspekt der vorliegenden Erfindung wird eine elektrische Steuereinheit zur Verfügung gestellt. Dieses Steuergerät umfasst eine Leiterplatte und einen Leistungshalbleiterbauelement auf der Oberseite der Leiterplatte, ein Wärmeleitelement, das mit dem Leistungshalbleiterbauelement durch eine Öffnung in der Leiterplatte in thermischem Kontakt steht, einen auf der Unterseite der Leiterplatte angeordneten Kühlkörper zur Abfuhr der beim Betrieb des Leistungshalbleiterbauelements auftretenden Wärme, eine auf der Unterseite der Leiterplatte flach anliegende Stromschiene, die mit dem Wärmeleitelement in thermischem und elektrischem Kontakt steht, wobei das Wärmeleitelement zur Stromzufuhr oder -abfuhr für das Leistungshalbleiterbauelement durch die Öffnung in der Leiterplatte in elektrischem Kontakt mit dem Leistungshalbleiterbauelement steht, und der Kühlkörper auf der Stromschiene angeordnet ist und mit dieser in thermischem Kontakt steht.

Vorteilhafterweise sind der Kühlkörper und die Stromschiene durch eine wärmeleitende Isolierschicht, vorzugsweise durch eine Klebefolie oder Kleberschicht, galvanisch getrennt. Auf diese Weise kann die Betriebssicherheit der Steuereinheit deutlich erhöht werden.

Vorteilhafterweise wird die Stromschiene durch einen ebenen, im wesentlichen rechteckigen Blechstreifen gebildet. Dadurch kann eine besonders einfache und kostengünstige Herstellung der Steuereinheit sichergestellt werden.

Vorzugsweise wird das Wärmeleitelement und die Stromschiene einstückig als Tiefziehteil aus einem Blechstreifen ausgeführt. Alternativ kann das Wärmeleitelement auch aus einem im wesentlichen zylindrischen, massiven Metallstück bestehen. In diesem Fall wird die Stromschiene vorzugsweise aus einem ebenen Blechstreifen gebildet, der mit einem Stanzloch versehenen ist, in das das Wärmeleitelement eingepresst ist. In beiden Fällen kann so eine einfache und kostengünstige Herstellung sichergestellt werden.

Vorteilhafterweise weist das Wärmeleitelement einen Zapfen auf, der in die Öffnung der Leiterplatte hineinragt, so dass die Oberseite des Zapfen mit der Oberseite der Leiterplatte bündig abschließt. Vorzugsweise passt der Zapfen formschlüssig in die Öffnung in der Leiterplatte. Damit kann sichergestellt werden, dass das Leistungshalbleiterbauelement plan auf der Oberseite der Leiterplatte und des Zapfens aufliegt.

Vorteilhafterweise steht die Unterseite des Leistungshalbleiterbauelements mit der Oberseite des Zapfens elektrisch und thermisch in Kontakt und ist vorzugsweise mit dieser verlötet. Dadurch kann eine sichere thermische und elektrische Kontaktierung zwischen dem Leistungshalbleiterbauelement und dem Wärmeleitelement gewährleistet werden.

Vorteilhafterweise liegt die Unterseite des Leistungshalbleiterbauelements auf der Oberseite des Zapfens und auf der Oberseite der Leiterplatte auf. Dadurch kann sichergestellt werden, dass das Leistungshalbleiterbauelement sowohl mit den Leiterbahnen auf der Leiterplatte als auch mit dem Wärmeleitelement verlötet werden kann.

Vorteilhafterweise ist die Stromschiene mit einer Steckzunge für eine Steckverbindung zum Anschluss eines Kabels zur Ein- oder Ausleitung des Stroms versehen. Alternativ kann die Stromschiene auch mit einem Gewindebolzen oder einer Crimpverbindung zum Anschluss eines Kabels zur Ein- oder Ausleitung des Stroms versehen sein. In beiden Fällen ist eine sichere Kontaktierung und einfache Fertigung gewährleistet.

Vorteilhafterweise weist die Stromschiene hochgestellte Befestigungselemente auf, die mit Bohrungen in der Leiterplatte kraftschlüssig verbunden sind. Auf diese Weise wird eine sichere Vormontage ermöglicht.

Vorteilhafterweise ist die elektrische Steuereinheit mit einer zweiten gleichartigen Stromschiene versehen, wobei eine der beiden Stromschienen der Stromzufuhr und die jeweils andere Stromschiene der Stromabfuhr für das Leistungshalbleiterbauelement dient. In diesem Fall wird der Kühlkörper vorzugsweise auf beiden Stromschienen angeordnet und durch eine Isolierschicht galvanisch getrennt.

Vorteilhafterweise ist das Leistungshalbleiterbauelement als SMD-Baustein ausgeführt. Damit kann die Steuereinheit besonders kompakt gefertigt werden.

Vorteilhafterweise sind auf der Leiterplatte eine Mehrzahl von Leistungshalbleiterbauelementen angeordnet, die durch jeweils eine Öffnung in der Leiterplatte mit der Stromschiene elektrisch und thermisch verbunden sind. Auf diese Weise können mehrere Leistungshalbleiterbauelemente mit Strom versorgt und zugleich über einen gemeinsamen Kühlkörper gekühlt werden.

Gemäß einem zweiten Aspekt der vorliegenden Erfindung wird ein Herstellungsverfahren für eine elektrische Steuereinheit mit einem Leistungshalbleiterbauelement auf der Oberseite einer Leiterplatte, einem Wärmeleitelement, das mit dem Leistungshalbleiterbauelement durch eine Öffnung in der Leiterplatte in thermischem und elektrischem Kontakt steht, einer auf der Unterseite der Leiterplatte flach anliegenden Stromschiene, die mit dem Wärmeleitelement in thermischem und elektrischem Kontakt steht, und einem auf der Stromschiene angeordneten Kühlkörper zur Abfuhr der beim Betrieb des Leistungshalbleiterbauelements auftretenden Wärme zur Verfügung gestellt. Das Herstellungsverfahren umfasst die Schritte Erstellen einer Unterbaugruppe durch vorläufige mechanische Fixierung der Leiterplatte auf der Stromschiene, wobei die Stromschiene zumindest einen Zapfen aufweist, der von unten in eine zugehörige Öffnung der Leiterplatte hineinragt, so dass die Oberseite des Zapfen mit der Oberseite der Leiterplatte bündig abschließt, Auftragen von Lötpaste auf der Oberseite der Unterbaugruppe, Bestücken der Oberseite der Unterbaugruppe mit dem Leistungshalbleiterbauelement, so dass das Leistungshalbleiterbauelement auf der Oberseite der Leiterplatte und der Oberseite des Zapfen aufliegt, und Verlöten des Leistungshalbleiterbauelements mit der Leiterplatte und dem Zapfen.

Vorteilhafterweise wird zusätzlich ein Kühlkörper auf der Unterseite der Stromschiene, vorzugsweise über eine wärmeleitende elektrische Isolationsschicht, mit der Stromschiene verbunden.

Vorteilhafterweise weist die Stromschiene einen elektrischen Anschluss auf, der auf einer Seite der Unterbaugruppe herausragt.

Vorteilhafterweise wird die Lötpaste mittels Siebdruck aufgetragen. Desweiteren wird das Leistungshalbleiterbauelement mit der Leiterplatte und dem Zapfen vorzugsweise durch Aufschmelzlöten verlötet. Vorteilhafterweise erfolgen die Schritte des Auftragens der Lötpaste, des Bestückens und des Verlötens in einer Standard-SMD-Fertigungslinie. Dadurch kann die Steuereinheit besonders effizient und konstengünstig mit bestehenden Produktionsanlagen hergestellt werden.

Vorzugsweise wird der Zapfen der Stromschiene durch Tiefziehen eines Blechstreifens gefertigt. Alternativ kann der Zapfen der Stromschiene durch Einpressen massiv metallischer Wärmeleitelemente in einen entsprechend gestanzten Blechstreifen erstellt werden. Auf diese Weise kann die Stromschiene zusammen mit den Wärmeleitelementen besonders kostengünstig produziert werden.

Vorteilhafterweise wird die Leiterplatte auf der Stromschiene durch Einpressen der Zapfen in die Öffnungen der Leiterplatte vorläufig mechanisch fixiert. Vorteilhafterweise kann die Stromschiene zusätzlich oder alternativ dazu hochgestellte Befestigungselemente aufweisen, die mit Bohrungen in der Leiterplatte kraftschlüssig verbunden werden, so dass die Leiterplatte auf der Stromschiene vorläufig mechanisch fixiert wird. Damit bildet die Leiterplatte zusammen mit der Stromschiene eine bauliche Einheit, die leicht weiter bearbeitet, insbesondere mit elektronischen Bauelementen bestückt werden kann.

Vorzugsweise wird dieses Herstellungsverfahren insbesondere zur Herstellung einer Steuereinheit gemäß dem ersten Aspekt der vorliegenden Erfindung verwendet.

Die Erfindung wird im folgenden unter Bezugnahme auf die beigefügten Abbildungen beschrieben, in denen:
- Fig. 1: eine beispielhafte elektrische Steuereinheit gemäß einer Ausführungsform der vorliegenden Erfindung zeigt,
- Fig. 2A: einen Aufriss der Steuereinheit aus Fig. 1 zeigt,
- Fig. 2B: einen Schnitt entlang der Linie A-A in Fig. 2A zeigt,
- Fig. 2C: ein Detail aus Fig. 2B zeigt,
- Fig. 2D: ein Detail aus Fig. 2C zeigt,
- Fig. 3A: eine Ausführungsform der Stromschiene gemäß einem Aspekt der vorliegenden Erfindung zeigt,
- Fig. 3B: eine alternative Ausführungsform der Stromschiene gemäß einem weiteren Aspekt der vorliegenden Erfindung zeigt,
- Fig. 3C: eine Ausführungsform der bestücken Platine zeigt,
- Fig. 4A: einen Aufriss der Steuereinheit gemäß einer alternativen Ausführungsform der vorliegenden Erfindung zeigt,
- Fig. 4B: einen Schnitt entlang der Linie B-B in Fig. 4A zeigt,
- Fig. 4C: ein Detail aus Fig. 4B zeigt,

- Fig. 4D: ein Detail aus Fig. 4C zeigt,
- Fig. 5A: eine Steuereinheit gemäß einer weiteren alternativen Ausführungsform der vorliegenden Erfindung zeigt,
- Fig. 5B: einen Aufriss der Steuereinheit aus Fig. 5A zeigt,
- Fig. 6A: einen Aufriss einer Steuereinheit gemäß einer weiteren Ausführungsform der vorliegenden Erfindung zeigt,
- Fig. 6B: einen Schnitt entlang der Linie C-C in Fig. 6A zeigt, und
- Fig. 6C: eine perspektivische Ansicht der Stomschiene aus Fig. 6A und 6B zeigt.

### DETAILLIERTE BESCHREIBUNG

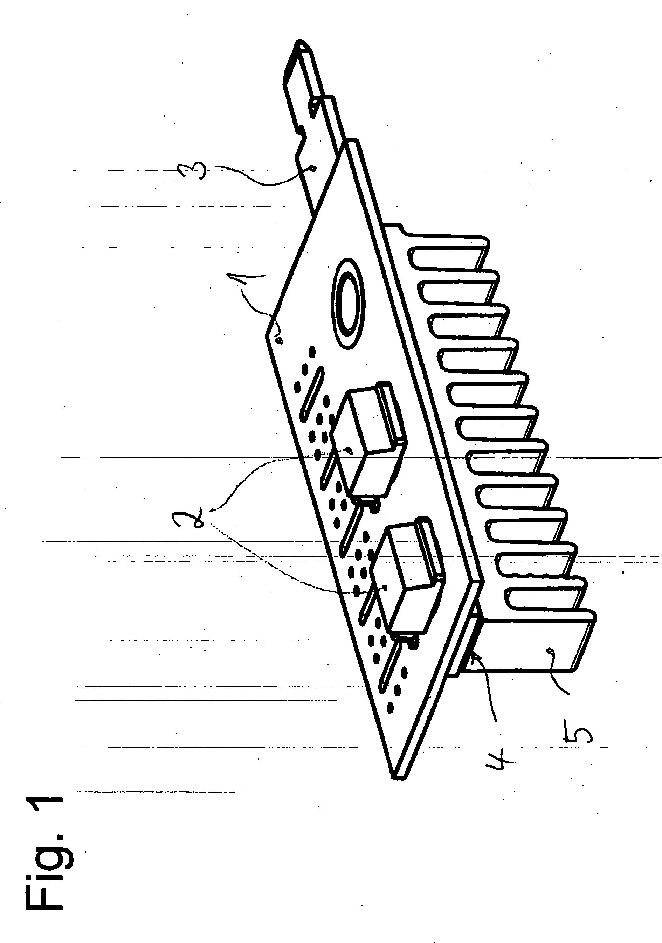

In Fig. 1 ist eine grundsätzliche Anordnung der Bauteile eines elektrischen Steuergeräts gemäß der vorliegenden Erfindung gezeigt. Das Steuergerät umfasst eine Leiterplatte (1), darauf gelötete Halbleiterschalter (2), eine speziell geformte Stromschiene (3), eine wärmeleitenden Isolierfolie (4) und einen beispielhaften Kühlkörper (5).

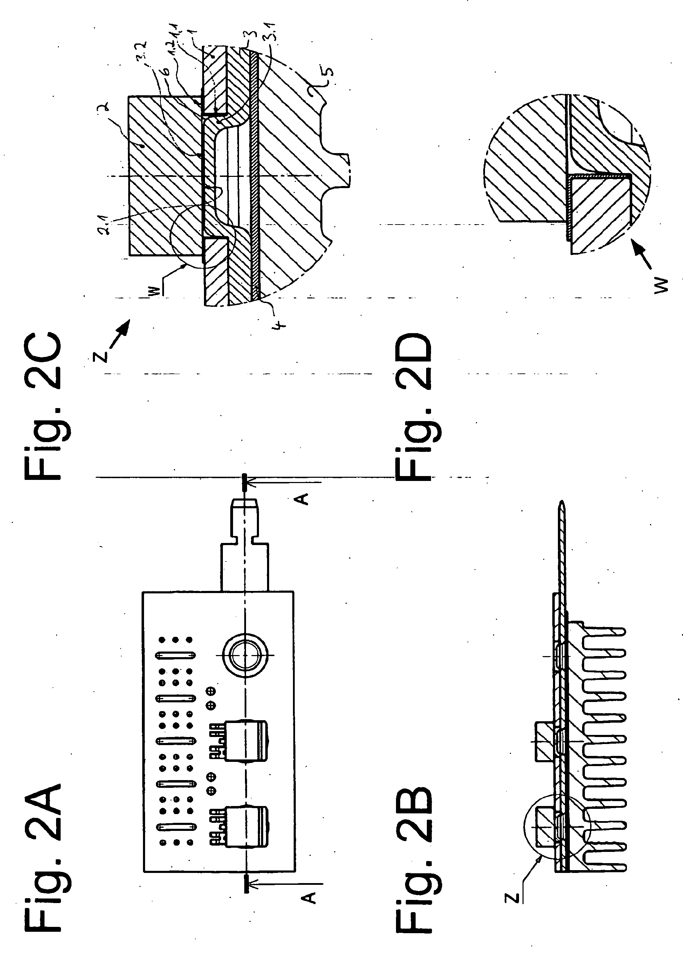

Eine erste Ausführungsform der vorliegenden Erfindung ist in Fig. 2A im Aufriss und in Figs. 2B-2D im Schnitt dargestellt. Eine Leiterplatte (1) mit mindestens einer Bohrung (1.1) wird mit einer planen Stromschiene (3) mit zapfenförmigen Ausprägungen (3.1) dergestalt miteinander gefügt, dass eine Vorfixierung für die weitere Verarbeitung vorliegt. Die Zapfen (3.1) der Stromschiene (3) werden dabei so tief in die Bohrungen (1.1) in der Leiterplatte (1) eingedrückt, dass die Oberseite der Zapfen (3.1) bündig mit der Leiterplattenoberfläche - d.h. der Kupferschicht (1.2) auf der Leiterplatte - abschließt. Die Stromschiene liegt dabei flach an der Unterseite der Leiterplatte an und trägt nur wenige Millimeter auf. Die so entstandene Unterbaugruppe ist derartig ausgeführt, dass sie wie eine normale Leiterplatte in einer Standard-SMD-Fertigungslinie weiterverarbeitet werden kann.

Die Halbleiterschalter (2) werden zusammen mit den anderen SMD-Bauteilen auf der Leiterplatte positioniert und verlötet. Sie liegen damit sowohl auf der Kupferschicht (1.2) der Leiterplatte als auch auf der Oberseite der Zapfen (3.1) auf. Es entsteht eine flächige Kontaktierung zwischen der Unterseite des Halbleiterschalters (2.1) und der Oberseite des Zapfens der Stromschiene (3.2), wobei das flüssige Lötzinn die Hohlräume (6) zwischen Halbleiterschalter (2), Zapfen (3.1) und Leiterplatte (1) ausfüllt. Damit wird eine optimale thermische und elektrische Verbindung zwischen Halbleiterschalter (2) und Stromschiene (3) erreicht.

Der Kühlkörper (5) wird nun großflächig - dadurch gut wärmeleitend - mit der Stromschiene (3) verbunden. Dies kann z.B. durch Kleben oder Pressen geschehen. Auch eine galvanische Trennung, also Isolierung, zwischen Stromschiene (3) und Kühlkörper (5) lässt sich auf einfache Weise durch eine möglichst dünne, und damit den Wärmeübergang kaum beeinflussende Isolierfolie (4) erreichen. Die Isolierfolie (4) kann auch als zweiseitige Klebefolie ausgestaltet sein und damit auch die Verbindungsfunktion übernehmen. Vom Montageablauf her ist ebenso eine Vormontage von Kühlkörper (5), Isolierfolie (4) und Stromschiene (3) vor dem Fügen mit der Stromschiene (3) in der Leiterplatte (1) denkbar. Alternativ kann die Klebefolie durch eine auf Kühlkörper oder Stromschiene aufgetragene Kleberschicht ersetzt werden.

Für den Kühlkörper werden vorzugsweise vorgefertigte Aluminiumprofile verwendet. Anstelle eines Aluminiumprofils kann aber zum Beispiel auch die metallische Bodenplatte eines Gehäuses oder dergleichen verwendet werden. In der Bodenplatte können dann auf der Innenseite entsprechende streifenförmige Vertiefungen für die Stromschiene vorgesehen sein, so dass nach der Montage sowohl Stromschiene wie auch Leiterplatte auf der Bodenplatte aufliegen.

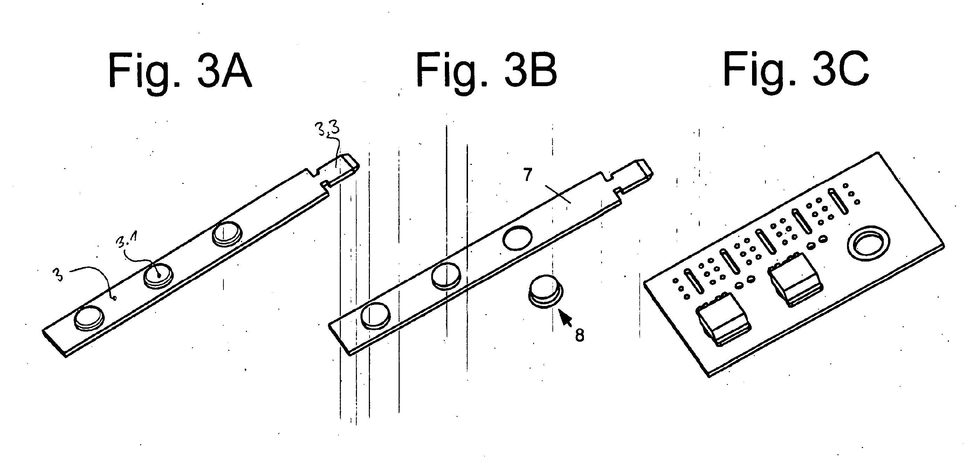

In Fig. 3A ist die Ausgestaltung der Stromschiene (3) als Tiefziehteil mit Zapfen (3.1) dargestellt. Hierdurch ist eine sehr kostengünstige und präzise Herstellung der Stromschiene (3) möglich. Vorzugsweise wird die Stromschiene so aus einem ebenen, im wesentlichen rechteckigen Blechstreifen gefertigt, ohne dass weitere Verarbeitungsschritte erforderlich sind. Weiterhin ermöglicht dieses Fertigungsverfahren auf einfache Art und Weise eine sichere Stromein- bzw. -ausleitung aus der Stromschiene (3) z.B. in ein Kabel, in dem ein Ende der Stromschiene (3) als Steckkontakt (3.3) ausgeführt wird. Alternativ kann in die Stromschiene ein Kontakt-oder Gewindebolzen z.B. eingepresst werden, um darüber ein Kabel anzuschließen. Ebenso sind aber auch andere Kontaktierungsverfahren, wie z.B. eine Crimpverbindung möglich, die vorteilhafterweise direkt aus dem Blechstreifen ausgebildet werden kann.

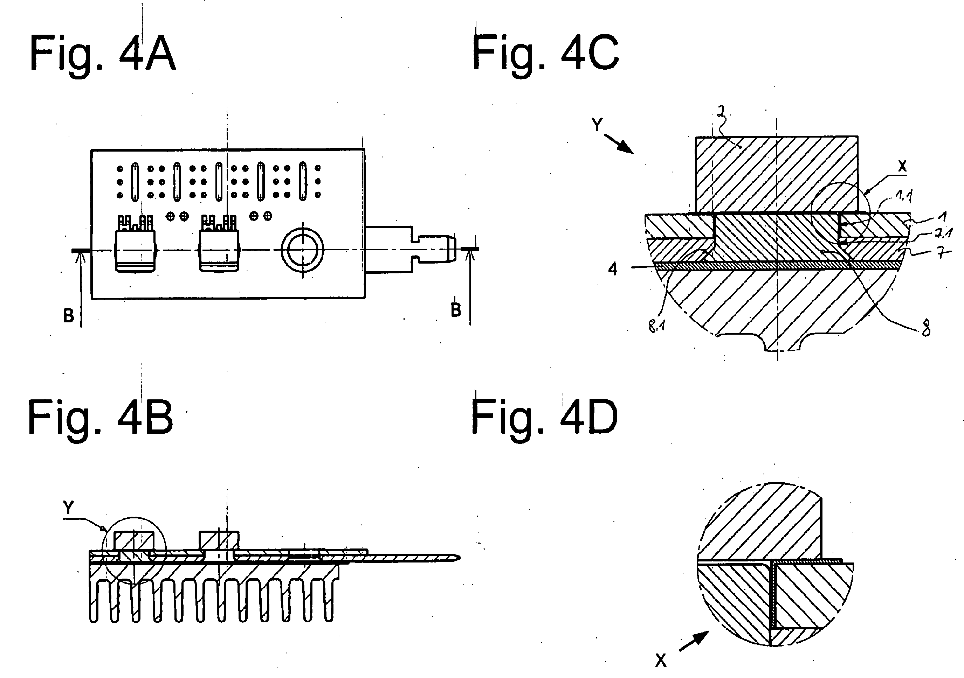

Eine zweite Ausführungsform der vorliegenden Erfindung ist in Fig. 4A im Aufriss und in Figs. 4B-4D als Schnittbild dargestellt. Die Stromschiene (7) ist als einfacher gestanzter Blechstreifen ausgestaltet. Vorzugsweise ist der Blechstreifen plan und im wesentlichen rechteckig. Die Zapfen, die in die Bohrungen in der Leiterplatte (1) eintauchen, werden im Gegensatz zur ersten Ausführungsform nicht aus dem Blechstreifen ausgeprägt, sondern als separates massives zylindrisches Teil (8) in den Blechstreifen (7) eingepresst (vgl. Fig. 3B). Somit kann die Stromschiene in besonders einfacher und kostengünstiger Weise gefertigt werden. Die weiteren Montageschritte erfolgen in der bereits oben beschriebenen Weise. Diese Anordnung hat den Vorteil einer noch besseren Wärmeanbindung der Stromschiene (7) an den Halbleiterschalter (2).

In Abwandlung dieser Variante ist es auch möglich, den Zapfen (8) zunächst in die Leiterplatte (1) zu verpressen und zu verlöten (vgl. Fig. 3C). Mit dieser Unterbaugruppe kann die Stromschiene mit Hilfe der Montagebohrungen (7.1) und der Zapfen (8) z.B. durch Anformen eines formschlüssigen Kragens (8.1) zusammengefügt werden.

Die Stromschiene mit den integrierten Wärmeleitelementen alleine (ohne Kühlkörper) hat zunächst die Aufgaben der Stromeinspeisung über den Steckkontakt, der Stromverteilung auf die einzelnen Leistungshalbleiter, der Wärmeauskopplung aus den Leistungshalbleitern und des Wärmetransports auf die andere Seite der Leiterplatte, also auf die Rückseite bezogen auf die Seite, auf der sich die Leistungshalbleiter befinden, verbunden mit einer Wärmespreizung. Wärmespreizung bedeutet, dass die Eintrittsfläche des Wärmestroms, kommend vom Leistungshalbleiter, kleiner ist als die Austrittsfläche des Wärmestroms aus dem Wärmeleitelement (als Teil der Stromschiene) in den Kühlkörper.

Der weitere Wärmetransport und die Wärmeabgabe z.B. an die umgebende Luft erfolgt dann durch einen separaten Kühlkörper. Durch die möglichst großflächige Anbindung des Kühlkörpers an die Stromschiene wird erreicht, dass eine dünne Isolierfolie zur elektrischen Isolierung zwischen diesen beiden Komponenten nur eine geringe Verschlechterung des Wärmeübergangs von Stromschiene in den Kühlkörper bewirkt (je größer die Übergangsflächen A, zwischen denen sich die Isolierfolie der Dicke d befindet, desto geringer ist der resultierende thermische Widerstand dieser Isolierfolie: Rₜₕ ∼ d / A).

Die Stromschiene mit den integrierten Wärmeleitelementen hat also thermisch die Aufgabe, eine guten Wärmetransport durch die Leiterplatte zu ermöglichen und im weiteren die Abwärme, vorzugsweise elektrisch isoliert, in einen Kühlkörper einzukoppeln.

Ein weiterer Vorteil der Stromschiene mit Wärmeableitfunktion gemäß der vorliegenden Erfindung besteht darin, dass durch die Stromschiene zusammen mit dem Kühlkörper eine thermische Kopplung zwischen den Halbleiterschaltern erfolgt. Kommt es in einem Halbleiterschalter z.B. durch eine Schädigung zu einer übermäßigen Erwärmung, so kann durch Ausschalten der anderen Halbleiterschalter dem beschädigten Halbleiterschalter der gesamte Kühlkörper zur Wärmeabfuhr zur Verfügung gestellt werden. Dadurch kann die Sicherheit im Fehlerfalle des Steuergeräts weiter erhöht werden.

Durch die vorliegende Erfindung wird eine wesentliche Vereinfachung in der Fertigung bzw. Montage dadurch erreicht, dass nicht mehrere einzelne Wärmeleitelemente in eine Leiterplatte montiert werden und anschließend mit einer Stromschiene verbunden werden müssen, sondern dass diese einzelnen Elemente in einem einzigen Herstellungsvorgang durch Stanzen und Umformen aus einem einfachen Blechstreifen hergestellt werden können. Gleichzeitig kann ein Ende dieses Blechstreifens auch noch als Steckzunge für eine Steckverbindung ausgestaltet werden. Die Stromschiene mit Wärmeableitfunktion kann also drei Funktionen ausweisen, nämlich Stromverteilung und Stromzuführung, Wärmeableitung und Zurverfügungstellung eines Steckkontakts.

Die erfindungsgemäße Stromschiene mit den integrierten Wärmeleitelementen wird bei der Verarbeitung in einem einzigen Montage- bzw. Fügeprozess mechanisch mit der Leiterplatte verbunden. Eine weitere elektrische und thermische Verbindung erfolgt dann durch den Lötprozess: Nachdem die Stromschiene mit der Leiterplatte vorläufig mechanisch verbunden ist, wird in einem Standard-SMD-Prozess die Lotpaste meist durch Siebdruck (auch auf die durch die Leiterplatte durchtauchenden Wärmeleitelemente) aufgebracht. Anschließend werden die Leistungshalbleiter und alle anderen elektronischen Bauteile bestückt. In dem sich darauf anschließenden Reflow-Lötprozess werden die Wärmeleitelemente mit der Leiterplatte, die Leistungshalbleiter mit der Leiterplatte und mit den Wärmeleitelementen sowie die restliche Bauteile mit der Leiterplatte gleichzeitig miteinander verlötet.

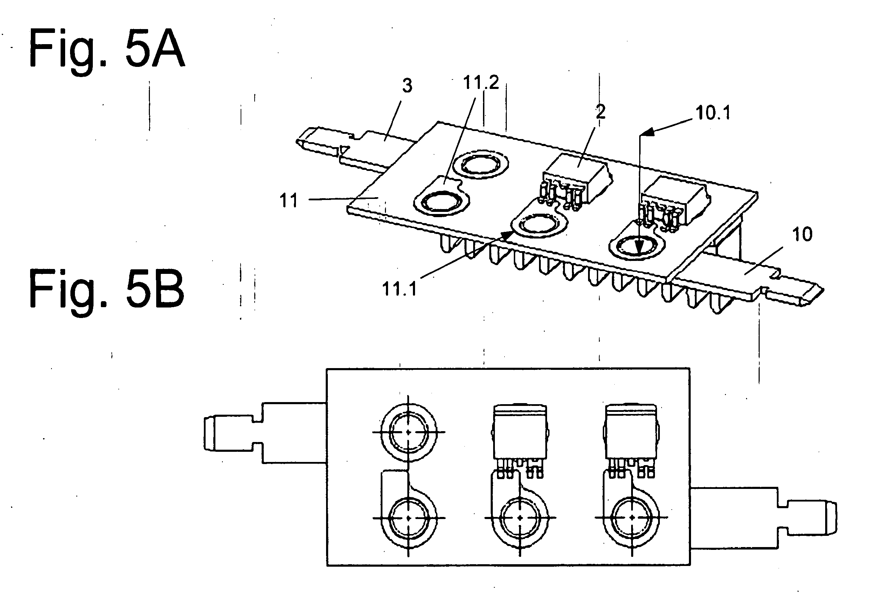

In Fig. 5 ist eine Anordnung mit einer zweiten Stromschiene (10) dargestellt. Diese kann gleich ausgeführt sein wie die erste Stromschiene (3), die zur Stromzuführung zu und zur Wärmeabfuhr von den Halbleiterschaltern dient. Diese Anordnung mit zwei Stromschienen kommt vorzugsweise dann zum Einsatz, wenn ein großer Strom in eine Leiterplatte eingeleitet, dort auf mehrere Halbleiterschalter aufgeteilt und dann der Strom wieder zusammengeführt werden muss. Dies ist immer dann erforderlich, wenn z.B. mehrere Halbleiterschalter auf einer Leiterplatte parallel geschaltet werden, um die Stromtragfähigkeit zu erhöhen. Die Zapfen der zweiten Stromschiene (10) tauchen genauso durch Bohrungen in der Leiterplatte durch; auf die Oberseite sind jedoch keine Halbleiterschalter aufgelötet. Die elektrische Anbindung der Stromschiene mit dem Zapfen an einen Halbleiterschalter oder ein sonstiges Bauteil auf der Leiterplatte erfolgt über eine Kupferfläche auf der Leiterplatte, die mit dem Zapfen verlötet wird.

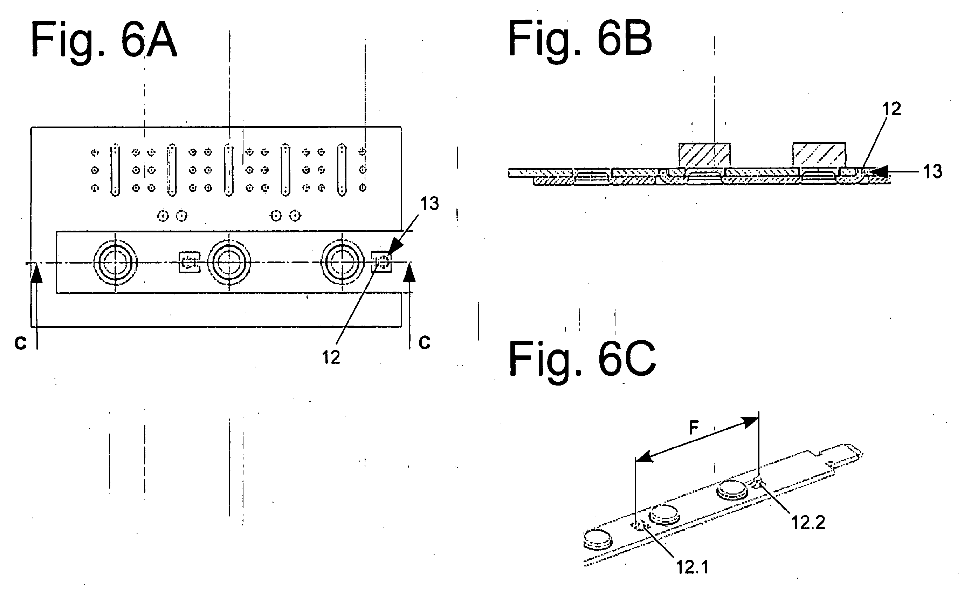

Fig. 6 zeigt eine mögliche zusätzlichen Befestigung zwischen Stromschiene und Leiterplatte. Dazu weist das Wärmeleitelement hochgestellte Befestigungselemente (12) auf, die mit Bohrungen (13) in der Leiterplatte derart verbunden werden, dass eine sichere Vormontage ermöglicht wird. Dies kann erfolgen, indem die Befestigungselemente mit einem Übermaß gefertigt werden, so dass eine Pressverbindung zu den Bohrungen der Leiterplatte entsteht. Alternativ kann aber auch durch Vorspannung (F) von mindestens zwei Befestigungselementen (12.1 und 12.2 in Fig. 6C) eine kraftschlüssige Verbindung mit der Leiterplatte erreicht werden.

Zusammenfassend kann festgestellt werden, dass die vorliegende Erfindung eine einfache und kostengünstige Stromzuführung und Wärmeabfuhr für oberflächenmontierte Halbleiterschalter ermöglicht. Zu diesem Zweck wird eine Stromschiene verwendet, die über ein Wärmeleitelement sowohl in elektrischem als auch in thermischem Kontakt mit dem Halbleiterschalter steht. Die beim Betrieb des Halbleiterschalters entstehende Wärme wird über einen auf der Stromschiene angeordneten Kühlkörper abgeführt. Die Stromschiene ist dabei ein einfaches, planes Bauteil, das an der Unterseite der Leiterplatte flach anliegt, und mit dieser eine Unterbaugruppe bildet, die zur Bestückung eine normale SMD-Fertigungslinie durchlaufen kann.

## Patentansprüche

1. Elektrische Steuereinheit mit
einer Leiterplatte (1) und einem Leistungshalbleiterbauelement (2) auf der Oberseite der Leiterplatte (1),
einem Wärmeleitelement (3.1; 8), das mit dem Leistungshalbleiterbauelement (2) durch eine Öffnung in der Leiterplatte (1) in thermischem Kontakt steht,
einem auf der Unterseite der Leiterplatte (1) angeordneten Kühlkörper (5) zur Abfuhr der beim Betrieb des Leistungshalbleiterbauelements (2) auftretenden Wärme,
**gekennzeichnet durch**
eine auf der Unterseite der Leiterplatte (1) flach anliegende Stromschiene (3; 7), die mit dem Wärmeleitelement (3.1; 8) in thermischem und elektrischem Kontakt steht, wobei
das Wärmeleitelement (3.1; 8) zur Stromzufuhr oder -abfuhr für das Leistungshalbleiterbauelement (2) **durch** die Öffnung in der Leiterplatte (1) in etektrischem-Kontakt mit dem Leistungshalbeiterbauelement (2) steht, und
der Kühlkörper (5) auf der Stromschiene (3; 7) angeordnet ist und mit dieser in thermischem Kontakt steht.

2. Elektrische Steuereinheit nach Anspruch 1, wobei der Kühlkörper (5) und die Stromschiene (3; 7) durch eine wärmeleitende Isolierschicht (4) galvanisch getrennt sind.

3. Elektrische Steuereinheit nach Anspruch 2, wobei die wärmeleitende Isolierschicht (4) als Klebefolie oder Kleberschicht ausgeführt ist.

4. Elektrische Steuereinheit nach einem der Ansprüche 1 bis 3, wobei die Stromschiene (3; 7) durch einen ebenen, im wesentlichen rechteckigen Blechstreifen gebildet wird.

5. Elektrische Steuereinheit nach einem der Ansprüche 1 bis 4, wobei das Wärmeleitelement (3.1; 8) und die Stromschiene (3; 7) einstückig als Tiefziehteil aus einem Blechstreifen ausgeführt sind.

6. Elektrische Steuereinheit nach einem der Ansprüche 1 bis 4, wobei das Wärmeleitelement (3.1; 8) durch ein im wesentlichen zylindrisches, massives Metallstück gebildet wird.

7. Elektrische Steuereinheit nach Anspruch 6, wobei die Stromschiene (3; 7) aus einem ebenen Blechstreifen gebildet wird, der mit einem Stanzloch versehenen ist, in dass das Wärmeleitelement (3.1; 8) eingepresst ist.

8. Elektrische Steuereinheit nach einem der Ansprüche 1 bis 7, wobei das Wärmeleitelement (3.1; 8) einen Zapfen (3.1) aufweist, der in die Öffnung der Leiterplatte (1) hineinragt, so dass die Oberseite (3.2) des Zapfen mit der Oberseite de Leiterplatte (1) bündig abschließt.

9. Elektrische Steuereinheit nach Anspruch 8, wobei der Zapfen (3.1) formschlüssig in die Öffnung in der Leiterplatte (1) passt.

10. Elektrische Steuereinheit nach dem Ansprüche 8 oder 9, wobei die Unterseite (2.1) des Leistungshalbleiterbauelements (2) mit der Oberseite (3.2) des Zapfens (3.1) elektrisch und thermisch in Kontakt steht.

11. Elektrische Steuereinheit nach einem der Ansprüche 8 bis 10, wobei die Unterseite (2.1) des Leistungshalbleiterbauelements (2) mit der Oberseite (3.2) des Zapfens (3.1) verlötet ist.

12. Elektrische Steuereinheit nach einem der Ansprüche 8 bis 11, wobei die Unterseite (2.1) des Leistungshalbleiterbauelements (2) auf der Oberseite (3.2) des Zapfens (3.1) und auf der Oberseite der Leiterplatte (1) aufliegt.

13. Elektrische Steuereinheit nach einem der Ansprüche 1 bis 12, wobei die Stromschiene (3; 7) mit einer Steckzunge (3.3) für eine Steckverbindung zum Anschluss eines Kabels zur Ein- oder Ausleitung des Stroms versehen ist.

14. Elektrische Steuereinheit nach einem der Ansprüche 1 bis 12, wobei die Stromschiene (3; 7) mit einem Gewindebolzen zum Anschluss eines Kabels zur Ein- oder Ausleitung des Stroms versehen ist.

15. Elektrische Steuereinheit nach einem der Ansprüche 1 bis 12, wobei die Stromschiene (3; 7) mit einer Crimpverbindung für den Anschluss eines Kabels zur Ein- oder Ausleitung des Stroms versehen ist.

16. Elektrische Steuereinheit nach einem der Ansprüche 1 bis 14, wobei die Stromschiene (3; 7) hochgestellte Befestigungselemente (12) aufweist, die mit Bohrungen (13) in der Leiterplatte (1) kraftschlüssig verbunden sind.

17. Elektrische Steuereinheit nach einem der Ansprüche 1 bis 16 mit einer zweiten gleichartigen Stromschiene (10), wobei eine der beiden Stromschienen (3; 7, 10) der Stromzufuhr und die jeweils andere Stromschiene (3; 7, 10) der Stromabfuhr für das Leistungslialbleiterbauelement (2) dient.

18. Elektrische Steuereinheit nach Anspruch 17, wobei der Kühlkörper (5) auf beiden Stromschienen (3; 7, 10) angeordnet ist und durch eine Isolierschicht (4) galvanisch getrennt ist.

19. Elektrische Steuereinheit nach einem der Ansprüche 1 bis 16, wobei das Leistungshalbleiterbauelement (2) als SMD-Baustein ausgeführt ist.

20. Elektrische Steuereinheit nach einem der Ansprüche 1 bis 19, wobei auf der Leiterplatte (1) eine Mehrzahl von Leistungshalbleiterbauelementen (2) angeordnet sind, die durch jeweils eine Öffnung in der Leiterplatte (1) mit der Stromschiene (3; 7) elektrisch und thermisch verbunden sind.

21. Herstellungsverfahren für eine elektrische Steuereinheit mit einem Leistungshalbleiterbauelement (2) auf der Oberseite einer Leiterplatte (1), einem Wärmeleitelement (3.1; 8), das mit dem Leistungshalbleiterbauelement (2) durch eine Öffnung in der Leiterplatte (1) in thermischem und elektrischem Kontakt steht, einer auf der Unterseite der Leiterplatte (1) flach anliegende Stromschiene (3, 7), die mit dem Wärmeleitelement (3.1; 8) in thermischem und elektrischem Kontakt steht, und einem auf der Stromschiene (3; 7) angeordneten Kühlkörper (5) zur Abfuhr der beim Betrieb des Leistungshalbleiterbauelements (2) auftretenden Wärme, umfassend die Schritte
Erstellen einer Unterbaugruppe durch vorläufige mechanische Fixierung der Leiterplatte (1) auf der Stromschiene (3; 7), wobei die Stromschiene (3; 7) zumindest einen Zapfen aufweist, der von unten in eine zugehörige Öffnung der Leiterplatte (1) hineinragt, so dass die Oberseite des Zapfen mit der Oberseite der Leiterplatte (1) bündig abschließt;
Auftragen von Lötpaste auf der Oberseite der Unterbaugruppe;
Bestücken der Oberseite der Unterbaugruppe mit dem Leistungshalbleiterbauelement, so dass das Leistungshalbleiterbauelement auf der Oberseite der Leiterplatte (1) und der Oberseite des Zapfen aufliegt; und
Verlöten des Leistungshalbleiterbauelements mit der Leiterplatte (1) und dem Zapfen.

22. Herstellungsverfahren nach Anspruch 21 mit dem zusätzlichen Schritt der Montage eines Kühlkörpers auf der Unterseite der Stromschiene (3; 7).

23. Herstellungsverfahren nach Anspruch 22, wobei der Kühlkörper über eine wärmeleitende elektrische Isolationsschicht mit der Stromschiene (3; 7) verbunden wird.

24. Herstellungsverfahren nach Anspruch 21 oder 22, wobei die Stromschiene (3; 7) einen elektrischen Anschluss aufweist, der auf einer Seite der Unterbaugruppe herausragt.

25. Herstellungsverfahren nach einem der Ansprüche 21 bis 24, wobei die Lötpaste mittels Siebdruck aufgetragen wird.

26. Herstellungsverfahren nach einem der Ansprüche 21 bis 24, wobei das Leistungshalbleiterbauelement mit der Leiterplatte (1) und dem Zapfen durch Aufschmelzlöten verlötet wird.

27. Herstellungsverfahren nach einem der Ansprüche 21 bis 26, wobei die Schritte des Auftragens der Lötpaste, des Bestückens und des Verlötens in einer Standard SMD-Fertigungslinie erfolgen.

28. Herstellungsverfahren nach einem der Ansprüche 21 bis 27 mit dem zusätzlichen Schritt des Erstellens der Zapfen der Stromschiene (3; 7) durch Tiefziehen eines Biechstreifens.

29. Herstellungsverfahren nach einem der Ansprüche 21 bis 27 mit dem zusätzlichen Schritt des Erstellens der Zapfen der Stromschiene (3; 7) durch Einpressen massiv metallischer Wärmeleitelemente in einen entsprechend gestanzten Blechstreifen.

30. Herstellungsverfahren nach einem der Ansprüche 21 bis 29, wobei die Leiterplatte (1) auf der Stromschiene (3; 7) durch Einpressen der Zapfen in die Öffnungen der Leiterplatte (1) vorläufig mechanisch fixiert wird.

31. Herstellungsverfahren nach einem der Ansprüche 21 bis 30, wobei die Stromschiene (3; 7) hochgestellte Befestigungselemente (12) aufweist, die mit Bohrungen (13) in der Leiterplatte (1) kraftschlüssig verbunden werden, so dass die Leiterplatte (1) auf der Stromschiene (3; 7) vorläufig mechanisch fixiert wird.

32. Herstellungsverfahren nach einem der Ansprüche 21 bis 31 zur Herstellung einer Steuereinheit nach einem der Ansprüche 1 bis 20.

## Claims

1. Electric control unit, comprising:
a circuit board (1) and a power semiconductor component (2) on the upper side of the circuit board (1);
a heat conducting element (3.1; 8), which is in thermal contact with the power semiconductor component (2) through an opening in the circuit board (1);
a heat sink (5) arranged on the bottom side of the circuit board (1) for removing heat generated during operation of the power semiconductor component (2),
**characterized by**
a bus bar (3; 7) that abuts plainly on the bottom side of the circuit board (1) and is in thermal and electrical contact with the heat conducting element (3.1; 8), wherein
the heat conducting element (3.1; 8) is in electrical contact with the power semiconductor component (2) through the opening in the circuit board (1) for feeding current to and removing current from the power semiconductor element (2), and
the heat sink (5) is arranged on and in thermal contact with the bus bar (3; 7).

2. Electric control unit according to claim 1, wherein the heat sink (5) and the bus bar (3; 7) are galvanically separated by a heat conducting insulating layer (4).

3. Electric control unit according to claim 2, wherein the heat conducting insulating layer (4) is an adhesive foil or adhesive layer.

4. Electric control unit according to any of claims 1 to 3, wherein the bus bar (3; 7) is formed by a flat and a substantially rectangular strip of sheet metal.

5. Electric control unit according to any of claims 1 to 4, wherein the heat conducting element (3.1; 8) and the bus bar (3; 7) are formed as a single part by deep drawing a strip of sheet metal.

6. Electric control unit according to any of claims 1 to 4, wherein the heat conducting element (3.1; 8) is formed by a substantially cylindric, solid piece of metal.

7. Electric control unit according to claim 6, wherein the bus bar (3; 7) is formed from a planar strip of sheet metal, which is provided with a punched hole into which the heat conducting element (3.1; 8) is pressed.

8. Electric control unit according to any of claims 1 to 7, wherein the heat conducting element (3.1; 8) is provided with a pin (3.1), which protrudes into the opening of the circuit board (1) such that the upper side (3.2) of the pin is flush with the upper side of the circuit board (1).

9. Electric control unit according to claim 8, wherein the pin (3.1) fits positively into the opening of the circuit board (1).

10. Electric control unit according to claim 8 or 9, wherein the bottom side (2.1) of the power semiconductor component (2) is in electrical and thermal contact with the upper side (3.2) of the pin (3.1).

11. Electric control unit according to any of claims 8 to 10, wherein the bottom side (2.1) of the power semiconductor component (2) is soldered to the upper side (3.2) of the pin (3.1).

12. Electric control unit according to any of claims 8 to 11, wherein the bottom side (2.1) of the power semiconductor component (2) abuts on the upper side (3.2) of the pin (3.1) and on the upper side of the circuit board (1).

13. Electric control unit according to any of claims 1 to 12, wherein the bus bar (3; 7) is provided with a blade terminal (3.3) of a pluggable contact for connecting a cable for feeding current in or out.

14. Electric control unit according to any of claims 1 to 12, wherein the bus bar (3; 7) is provided with a threaded stud for connecting a cable for feeding current in or out.

15. Electric control unit according to any of claims 1 to 12, wherein the bus bar (3; 7) is provided with a crimp connection for connecting a cable for feeding current in or out.

16. Electric control unit according to any of claims 1 to 14, wherein the bus bar (3; 7) is provided with raised mounting elements (12) that are friction locked to drillings (13) in the circuit board (1).

17. Electric control unit according to any of claims 1 to 16, further comprising a second bus bar (10) of the same kind, wherein one of the two bus bars (3; 7, 10) serves for feeding current to the power semiconductor component (2) and the other bus bar serves for removing current from the power semiconductor component (2).

18. Electric control unit according to claim 17, wherein the heat sink (5) is arranged on both bus bars (3; 7, 10) and galvanically separated therefrom by an insulating layer (4).

19. Electric control unit according to any of claims 1 to 16, wherein the power semiconductor component (2) is configured as a surface mounted device.

20. Electric control unit according to any of claims 1 to 19, wherein a plurality of power semiconductor components (2) is arranged on the circuit board (1), each of which being electrically and thermally connected to the bus bar (3; 7) through a respective opening in the circuit board (1).

21. Method for manufacturing an electric control unit with a power semiconductor component (2) on the upper side of a circuit board (1), a heat conducting element (3.1; 8), which is in thermal and electrical contact with the power semiconductor component (2) through an opening in the circuit board (1), a bus bar (3; 7), which abuts plainly on the bottom side of the circuit board (1) and is in thermal and electrical contact with the heat conducting element (3.1; 8), and a heat sink (5) arranged on the bus bar (3; 7) for removing heat generated during operation of the power semiconductor component (2), said method comprising the steps:
building a subassembly by preliminarily mechanically fixing the circuit board (1) on the bus bar (3; 7,) wherein the bus bar (3; 7) is provided with at least one pin protruding into a corresponding opening of the circuit board (1) from below such that the upper side of the pin is flush with the upper side of the circuit board (1);
applying soldering paste on the upper side of the subassembly;
equipping the upper side of the subassembly with the power semiconducting component such that the power semiconducting component abuts on the upper side of the circuit board (1) and on the upper side of the pin; and
soldering the power semiconductor component to the circuit board (1) and to the pin.

22. Method according to claim 21 further comprising the step of mounting a heat sink to the bottom side of the bus bar (3; 7).

23. Method according to claim 22, wherein the heat sink is connected to the bus bar (3; 7) via a heat conducting, electrically insulating layer.

24. Method according to claim 21 or 22, wherein the bus bar (3; 7) is provided with an electric terminal, which protrudes at one side of the subassembly.

25. Method according to any of claims 21 to 24, wherein the soldering paste is applied by means of screen printing.

26. Method according to any of claims 21 to 24, wherein the power semiconductor component is soldered to the circuit board (1) and the pin by means of reflow soldering.

27. Method according to any of claims 21 to 26, wherein the steps of applying the soldering paste, the equipping, and the soldering are performed in a conventional SMD production line.

28. Method according to any of claims 21 to 27, further comprising the step of forming the pin of the bus bar (3; 7) by deep drawing a strip of sheet metal.

29. Method according to any of claims 21 to 27, further comprising the step of forming the pin of the bus bar (3; 7) by pressing solid metallic heat conducting elements in a strip of sheet metal punched accordingly.

30. Method according to any of claims 21 to 29, wherein the circuit board 1 is preliminarily mechanically fixed on the bus bar (3; 7) by pressing the pin into the openings of the circuit board (1).

31. Method according to any of claims 21 to 30, wherein the bus bar (3; 7) is provided with raised mounting elements (12), that are friction locked to drillings (13) in the circuit board (1) such that the circuit board (1) is preliminarily mechanically fixed on the bus bar (3; 7).

32. Method according to any of claims 21 to 31 for manufacturing a control unit according to any of claims to 1 to 20.

## Revendications

1. Unité de commande électrique avec
une carte imprimée (1) et un composant à semi-conducteur de puissance (2) sur la face supérieure de la carte imprimée (1),
un élément conducteur de chaleur (3.1 ; 8) qui est en contact thermique avec le composant à semi-conducteur de puissance (2) grâce à une ouverture prévue dans la carte imprimée (1),
un corps de refroidissement (5) qui est disposé sur la face inférieure de la carte imprimée (1) pour évacuer la chaleur produite lors du fonctionnement du composant à semi-conducteur de puissance (2),
**caractérisée par**
un rail conducteur (3 ; 7) qui est posé à plat sur la face inférieure de la carte imprimée (1) et qui est en contact thermique et électrique avec l'élément conducteur de chaleur (3.1 ; 8), étant précisé que
l'élément conducteur de chaleur (3.1 ; 8), en vue de l'amenée et de l'évacuation de courant pour le composant à semi-conducteur de puissance (2), est en contact électrique avec ledit composant (2) grâce à l'ouverture prévue dans la carte imprimée (1), et que
le corps de refroidissement (5) est disposé sur le rail conducteur (3 ; 7) et est en contact thermique avec celui-ci.

2. Unité de commande électrique selon la revendication 1, dans laquelle le corps de refroidissement (5) et le rail conducteur (3 ; 7) sont isolés électriquement par une couche isolante conductrice de chaleur (4).

3. Unité de commande électrique selon la revendication 2, dans laquelle la couche isolante conductrice de chaleur (4) est conçue comme un film adhésif ou une couche de colle.

4. Unité de commande électrique selon l'une des revendications 1 à 3, dans laquelle le rail conducteur (3 ; 7) est formé par une bande de tôle plane globalement rectangulaire.

5. Unité de commande électrique selon l'une des revendications 1 à 4, dans laquelle l'élément conducteur de chaleur (3.1 ; 8) et le rail conducteur (3 ; 7) sont réalisés d'une seule pièce sous la forme d'une pièce emboutie, à partir d'une bande de tôle.

6. Unité de commande électrique selon l'une des revendications 1 à 4, dans laquelle l'élément conducteur de chaleur (3.1 ; 8) est formé par une pièce métallique pleine globalement cylindrique.

7. Unité de commande électrique selon la revendication 6, dans laquelle le rail conducteur (3 ; 7) est formé à partir d'une bande de tôle plane qui est pourvue d'un trou découpé dans lequel l'élément conducteur de chaleur (3.1 ; 8) est enfoncé.

8. Unité de commande électrique selon l'une des revendications 1 à 7, dans laquelle l'élément conducteur de chaleur (3.1 ; 8) présente une saillie (3.1) qui dépasse dans l'ouverture de la carte imprimée (1) de sorte que la face supérieure (3.2) de ladite saillie affleure la face supérieure de la carte imprimée (1).

9. Unité de commande électrique selon la revendication 8, dans laquelle la saillie (3.1) entre par complémentarité de forme dans l'ouverture de la carte imprimée (1).

10. Unité de commande électrique selon la revendication 8 ou 9, dans laquelle la face inférieure (2.1) du composant à semi-conducteur de puissance (2) est en contact électrique et thermique avec la face supérieure (3.2) de la saillie (3.1).

11. Unité de commande électrique selon l'une des revendications 8 à 10, dans laquelle la face inférieure (2.1) du composant à semi-conducteur de puissance (2) est reliée par brasage à la face supérieure (3.2) de la saillie (3.1).

12. Unité de commande électrique selon l'une des revendications 8 à 11, dans laquelle la face inférieure (2.1) du composant à semi-conducteur de puissance (2) est posée sur la face supérieure (3.2) de la saillie (3.1) et sur la face supérieure de la carte imprimée (1).

13. Unité de commande électrique selon l'une des revendications 1 à 12, dans laquelle le rail conducteur (3 ; 7) est pourvu d'une languette d'enfichage (3.3) pour un enfichage en vue du raccordement d'un câble d'amenée ou de sortie du courant.

14. Unité de commande électrique selon l'une des revendications 1 à 12, dans laquelle le rail conducteur (3 ; 7) est pourvu d'une tige filetée pour le raccordement d'un câble d'amenée ou de sortie du courant.

15. Unité de commande électrique selon l'une des revendications 1 à 12, dans laquelle le rail conducteur (3, 7) est pourvu d'une liaison sertie pour le raccordement d'un câble d'amenée ou de sortie du courant.

16. Unité de commande électrique selon l'une des revendications 1 à 14, dans laquelle le rail conducteur (3 ; 7) présente des éléments de fixation surélevés (12) qui sont reliés par force à des perçages (13) de la carte imprimée (1).

17. Unité de commande électrique selon l'une des revendications 1 à 16, avec un second rail conducteur (10) du même type, l'un des deux rails conducteurs (3 ; 7, 10) servant à l'amenée de courant et l'autre rail conducteur (3 ; 7, 10) à l'évacuation de courant pour le composant à semi-conducteur de puissance (2).

18. Unité de commande électrique selon la revendication 17, dans laquelle le corps de refroidissement (5) est disposé sur les deux rails conducteurs (3 ; 7, 10) et est séparé électriquement par une couche isolante (4).

19. Unité de commande électrique selon l'une des revendications 1 à 16, dans laquelle le composant à semi-conducteur de puissance (2) est conçu comme un composant monté en surface.

20. Unité de commande électrique selon l'une des revendications 1 à 19, dans laquelle il prévu sur la carte imprimée (1) plusieurs composants à semi-conducteurs de puissance (2) qui sont reliés électriquement et thermiquement au rail conducteur (3 ; 7) à travers des ouvertures respectives prévues dans la carte imprimée (1).

21. Procédé de fabrication pour une unité de commande électrique avec un composant à semi-conducteur de puissance (2) sur la face supérieure d'une carte imprimée (1), un élément conducteur de chaleur (3.1 ; 8) qui est en contact thermique et électrique avec le composant à semi-conducteur de puissance (2) grâce à une ouverture prévue dans la carte imprimée (1), un rail conducteur (3, 7) qui est posé à plat sur la face inférieure de la carte imprimée (1) et qui est en contact thermique et électrique avec l'élément conducteur de chaleur (3.1 ; 8), et un corps de refroidissement (5) qui est disposé sur le rail conducteur (3 ; 7) pour évacuer la chaleur produite lors du fonctionnement du composant à semi-conducteur de puissance (2), comprenant les étapes suivantes :
construction d'un sous-ensemble par fixation mécanique provisoire de la carte imprimée (1) sur le rail conducteur (3 ; 7), le rail conducteur (3 ; 7) présentant au moins une saillie qui dépasse par-dessous dans une ouverture associée de la carte imprimée (1) de sorte que la face supérieure de ladite saillie affleure la face supérieure de la carte imprimée (1) ;
application de pâte à braser sur la face supérieure du sous-ensemble ;
garnissage de la face supérieure du sous-ensemble avec le composant à semi-conducteur de puissance de telle sorte que ledit composant soit appliqué sur la face supérieure de la carte imprimée (1) et sur la face supérieure de la saillie ; et
liaison par brasage du composant à semi-conducteur de puissance avec la carte imprimée (1) et la saillie.

22. Procédé de fabrication selon la revendication 21, avec l'étape supplémentaire du montage d'un corps de refroidissement sur la face inférieure du rail conducteur (3 ; 7) .

23. Procédé de fabrication selon la revendication 22, selon lequel le corps de refroidissement est relié au rail conducteur (3 ; 7) par une couche isolante électrique conductrice de chaleur.

24. Procédé de fabrication selon la revendication 21 ou 22, selon lequel le rail conducteur (3 ; 7) présente un raccordement électrique qui dépasse d'une face du sous-ensemble.

25. Procédé de fabrication selon l'une des revendications 21 à 24, selon lequel la pâte à braser est appliquée par sérigraphie.

26. Procédé de fabrication selon l'une des revendications 21 à 24, selon lequel le composant à semi-conducteur de puissance est relié à la carte imprimée (1) et à la saillie par brasage par fusion.

27. Procédé de fabrication selon l'une des revendications 21 à 26, selon lequel les étapes d'application de la pâte à braser, de garnissage et de brasage sont réalisées sur une chaîne de fabrication de composants montés en surface standard.

28. Procédé de fabrication selon l'une des revendications 21 à 27, avec l'étape supplémentaire de la réalisation des saillies du rail conducteur (3 ; 7) par emboutissage d'une bande de tôle.

29. Procédé de fabrication selon l'une des revendications 21 à 27, avec l'étape supplémentaire de la réalisation des saillies du rail conducteur (3 ; 7) par enfoncement d'éléments métalliques pleins conducteurs de chaleur dans une bande de tôle découpée en conséquence.

30. Procédé de fabrication selon l'une des revendications 21 à 29, selon lequel la carte imprimée (1) est provisoirement fixée mécaniquement sur le rail conducteur (3 ; 7) par enfoncement des saillies dans les ouvertures de la carte imprimée (1).

31. Procédé de fabrication selon l'une des revendications 21 à 30, selon lequel le rail conducteur (3 ; 7) présente des éléments de fixation surélevés (12) qui sont reliés par force à des perçages (13) de la carte imprimée (1), de sorte que la carte imprimée (1) est provisoirement fixée mécaniquement sur le rail conducteur (3 ; 7) .

32. Procédé de fabrication selon l'une des revendications 21 à 31 pour la fabrication d'une unité de commande selon l'une des revendications 1 à 20.
